Europäisches Patentamt

European Patent Office

Office européen des brevets

(11) Numéro de publication: **0 124 406**
A1

## (12) DEMANDE DE BREVET EUROPEEN

(21) Numéro de dépôt: 84400685.8

(22) Date de dépôt: 06.04.84

(51) Int. Cl.³: **H 03 G 3/04**, G 05 B 19/21

(30) Priorité: 15.04.83 FR 8306219

(43) Date de publication de la demande: 07.11.84
Bulletin 84/45

(84) Etats contractants désignés: **BE CH DE GB IT LI NL**

(71) Demandeur: **THOMSON-CSF, 173, Boulevard Haussmann, F-75379 Paris Cedex 08 (FR)**

(72) Inventeur: **Michaud, Pierre, THOMSON-CSF SCPI 173, bld Haussmann, F-75379 Paris Cedex 08 (FR)**

(74) Mandataire: **Turlèque, Clotilde et al, THOMSON-CSF SCPI 173, Bld Haussmann, F-75379 Paris Cedex 08 (FR)**

(54) Dispositif de commande manuelle différentielle.

(57) Dispositif de commande manuelle différentielle.

L'invention concerne un dispositif permettant de régler une grandeur commandable par la valeur M d'un mot binaire, en actionnant un bouton poussoir (« + ») pour commander une augmentation de la grandeur, et un bouton poussoir («—»), pour commander une diminution de la grandeur.

Le dispositif comprend principalement des moyens (1) pour calculer à intervalles réguliers la valeur d'une variation de M quand l'un des commutateurs (« + » ou «—») actionné, la valeur absolue de cette variation augmentant avec une pente croissant rapidement en fonction du temps; des moyens (2) pour changer éventuellement le signe de la valeur de la variation; et des moyens (3) pour additioner la suite de toutes les valeurs de la variation, pour limier entre deux bornes la somme obtenue, et fournir ainsi la valeur M du mot binaire commandant la grandeur à régler.

Application, notamment, aux dispositifs numériques de traitement de signaux vidéo.

0124406

1

## Dispositif de commande manuelle différentielle

L'invention concerne un dispositif permettant à un opérateur de régler une grandeur, commandable électriquement, en actionnant deux commutateurs, l'un commandant une augmentation de la grandeur, l'autre commandant une diminution de la grandeur, la grandeur restant à une valeur constante lorsqu'aucun des deux commutateurs n'est actionné. Un tel dispositif est utilisé notamment pour fournir des valeurs de réglage à un dispositif numérique, par exemple un dispositif numérique de traitement de signaux vidéo.

Pour régler électriquement une grandeur dans un dispositif de traitement analogique, il est connu d'utiliser un potentiomètre. Un potentiomètre permet de faire un réglage précis en déplaçant lentement son curseur, et permet de parcourir rapidement toute la gamme de réglage en déplaçant rapidement son curseur. Pour fournir des valeurs de réglage à un dispositif de traitement numérique, un potentiomètre est peu adapté puisqu'il fournit une valeur analogique et non pas une valeur numérique. D'autre part il possède des inconvénients mécaniques, notamment l'usure. Il est connu de fournir une valeur de réglage à un dispositif numérique en actionnant deux commutateurs, l'un commandant une augmentation de la grandeur à régler, l'autre commandant une diminution de cette valeur, cette augmentation ou cette diminution se faisant à un rythme régulier par des variations dont la valeur absolue est constante. Ce procédé a pour inconvénient une lenteur de réglage lorsque la variation du réglage doit être importante. Il est connu aussi d'utiliser deux commutateurs correspondant à deux vitesses de réglage différentes, l'une pour réaliser un réglage grossier rapidement, l'autre pour réaliser un réglage fin lentement, la variation du réglage se faisant toujours dans le même sens. Ce type de dispositif est utilisé, par exemple, pour régler une horloge à affichage numérique. Il a pour inconvénient de ne pas permettre le choix entre une augmentation et une diminution de la grandeur. Si le réglage grossier dépasse la valeur souhaitée, il n'est pas possible de commander une diminution de la grandeur, avec le réglage fin, pour obtenir finale-

2

ment la valeur souhaitée. Dans ce cas, il est nécessaire d'actionner le réglage grossier pour faire parcourir à la grandeur toute sa gamme et la faire revenir à une valeur légèrement inférieure à la valeur souhaitée, puis d'utiliser le réglage fin pour obtenir la valeur souhaitée. Le dispositif selon l'invention remédie à ces inconvénients par des moyens simples.

Selon l'invention, un dispositif de commande manuelle différentielle, pour régler une grandeur commandable par la valeur M d'un mot binaire, est caractérisé en ce qu'il comporte :

- un premier commutateur manuel, pour commander une augmentation de la grandeur ;

- un second commutateur manuel pour commander une diminution de la grandeur ;

- des moyens pour calculer à intervalles réguliers la valeur absolue d'une variation de la valeur M, quand l'un des commutateurs est actionné, en fonction de la durée pendant laquelle il est actionné sans interruption ; la durée des intervalles étant choisie de façon à rendre imperceptible les discontinuités du réglage ;

- des moyens pour donner, à la valeur de la variation, un signe positif ou négatif selon le commutateur qui est actionné ;

- des moyens pour additionner la suite de toutes les valeurs de la variation et pour limiter entre deux bornes la somme obtenue, cette dernière constituant la valeur M du mot binaire commandant la grandeur à régler.

L'invention sera mieux comprise et d'autres détails apparaîtront à l'aide de la description ci-dessous et des figures l'accompagnant :

- les figures 1 et 2 représentent des diagrammes temporels illustrant le fonctionnement de deux exemples de réalisation du dispositif selon l'invention ;

- la figure 3 représente le schéma synoptique d'un premier exemple de réalisation du dispositif selon l'invention ;

- la figure 4 représente le schéma synoptique d'un second exemple de réalisation ;

- la figure 5 représente l'organigramme du fonctionnement du second exemple de réalisation du dispositif selon l'invention.

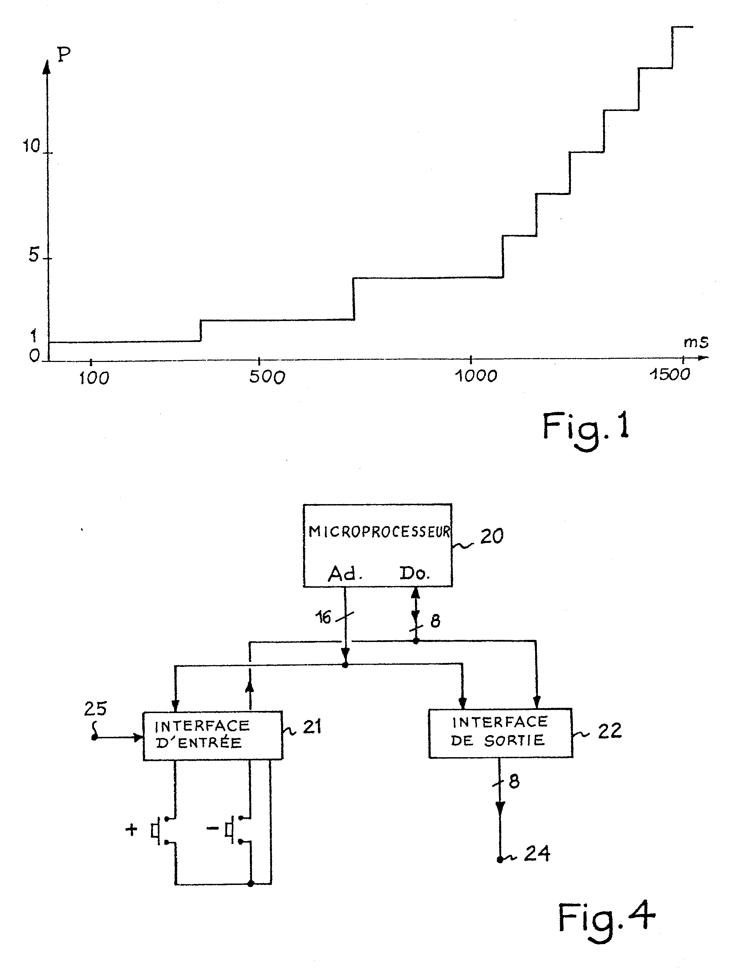

Le dispositif selon l'invention peut être appliqué, par exemple, pour régler une grandeur dans un dispositif de traitement numérique d'un signal vidéo, cette grandeur étant commandable par un mot binaire de huit bits dont la valeur décimale varie de 0 à 255 par pas d'une unité, pour obtenir la précision de réglage souhaitée. Le réglage est effectué à intervalles réguliers, de durée 20 mS, correspondant à la succession des trames d'images. La figure 1 représente le graphe de la valeur absolue P de la variation de la valeur du mot binaire sur un intervalle de 20 mS, autrement dit sa pente, en fonction du temps écoulé depuis l'instant où l'un des commutateurs de commande a été actionné, sans interruption. Le mot binaire lui-même a une certaine valeur de départ, non nulle en général, et qui résulte des réglages effectués avant l'instant considéré. La valeur absolue P de la variation est une fonction croissante du temps car le dispositif est utilisé dans deux cas différents :

- si le réglage de départ est proche du réglage souhaité, l'opérateur souhaite pouvoir ajuster ce réglage avec précision, c'est pourquoi la pente est faible dans la partie inférieure du graphe de P. Cette faible pente n'entraine pas une durée importante puisque la valeur finale du mot binaire est proche de la valeur de départ.

- Si le réglage de départ est éloigné du réglage souhaité, l'opérateur n'a pas besoin immédiatement de précision, par contre il souhaite parcourir rapidement la plage de réglage. C'est pourquoi il est prévu que la pente augmente rapidement dans la partie supérieure du graphe de P, de façon à augmenter la valeur de la variation de réglage effectuée toutes les 20 mS, ce qui permet de réduire la durée de l'excursion. Quand le réglage est proche de celui souhaité, l'opérateur relâche le commutateur qui était actionné, et il se trouve dans le cas précédent.

Pendant un premier intervalle allant de 0 à 360 mS, toutes les 20 mS la variation de la valeur est d'une unité, autrement dit la pente est d'une unité pour 20 mS. Pendant un second intervalle, allant de 360 mS à 720 mS, la pente est de deux unités pour 20 mS. Pendant un troisième intervalle, allant de 720 mS à 1080 mS, la pente est de quatre unités pour 20 mS. Pendant un quatrième intervalle, allant de 1080 mS à 1160 mS, la pente est de six unités pour 20 mS. Ensuite, la pente augmente de deux unités pour 20 mS toutes les 80 mS. Si le commutateur actionné est relâché puis actionné de nouveau la pente recommence à croître à partir de la valeur minimale, qui est égale à l'unité. Si le commutateur actionné est relâché, et si l'autre commutateur est actionné ensuite, la pente recommence à croître en valeur absolue à partir de la valeur minimale, mais avec un signe inversé.

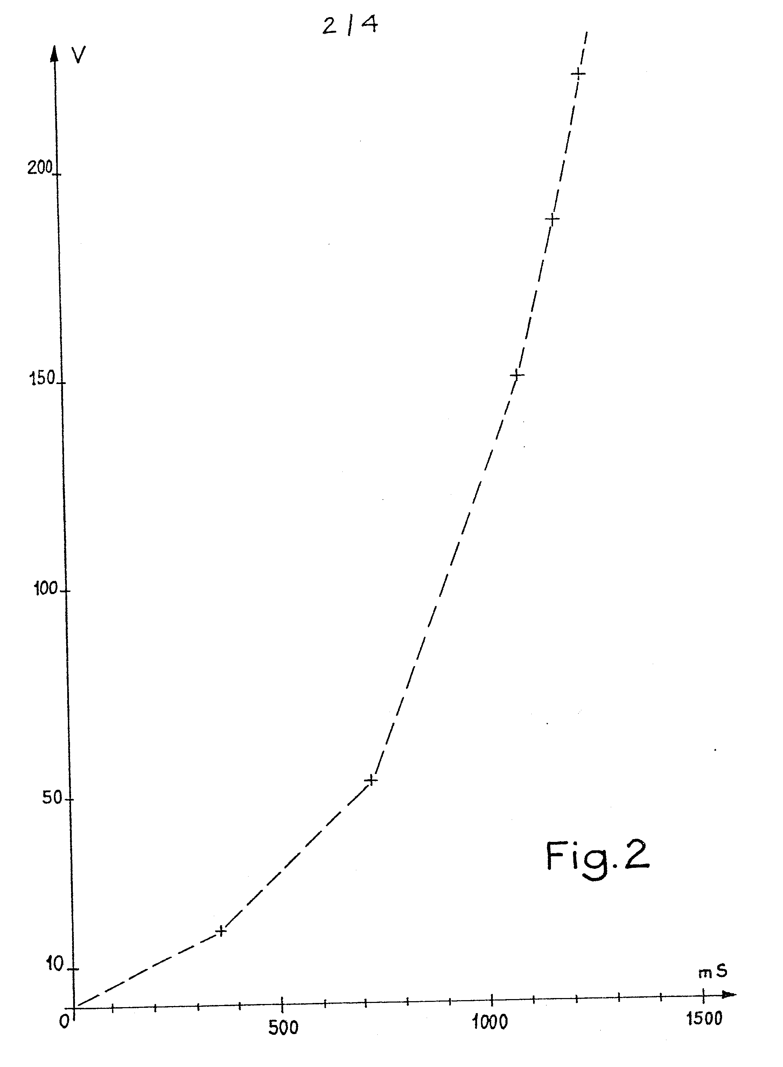

La figure 2 représente le graphe de la valeur absolue V de la variation du mot binaire commandant la grandeur qui est réglée par le dispositif selon l'invention. La valeur V de cette variation varie par saut toutes les 20 mS, mais le graphe ne représente pas ces sauts parce que leur amplitude et leur durée sont trop faibles pour être visibles sur le dessin. Pendant un premier intervalle de 0 à 360 mS la valeur V varie linéairement de 0 à 18, par pas d'une unité, ce qui permet d'effectuer un réglage avec une précision d'une unité. Pendant un second intervalle, allant de 360 mS à 720 mS, la valeur V varie linéairement de 18 à 54 par pas de deux unités. Pendant un troisième intervalle, allant de 720 mS à 1080 mS, la valeur V varie de 54 à 126, par pas de quatre unités. Pendant un quatrième intervalle, allant de 1080 mS à 1160 mS, la valeur V varie linéairement de 126 à 150, par pas de six unités. Pendant un cinquième intervalle, allant de 1160 mS à 1240 mS, la valeur V varie de 150 à 182, par pas de huit unités. Pendant un sixième intervalle allant de 1240 mS à 1320 mS, la valeur V varie de 182 à 222, par pas de dix unités. Pendant un sixième intervalle, allant de 1320 mS à 1400 mS, la valeur V varie de 222 à 270, par pas de douze unités. En pratique la valeur absolue de la variation ne dépasse jamais 255 puisque la valeur du mot binaire commandant la grandeur à régler est comprise entre 0 et 255. Si, par exemple, ce mot binaire a pour valeur 115 et si le réglage consiste à l'amener à la valeur 135, la valeur V de cette variation est 20, il faut actionner le commutateur d'augmentation pendant environ 360 mS. Si, en actionnant trop longtemps le commutateur, la grandeur atteint la valeur 140 au lieu de la valeur 135 souhaitée, une variation de valeur absolue 5 est encore nécessaire, mais en sens opposé. L'opérateur relâche le commutateur d'augmentation et actionne le commutateur de diminution pendant une durée d'environ 200 mS. Il est à remarquer que la faible pente de la variation entre 0 et 500 mS permet alors de réaliser un réglage fin alors que la forte pente entre 500 et 1500 mS permet de réaliser un réglage rapide sur toute la gamme. L'utilisation de deux commutateurs, commandant soit l'augmentation, soit la diminution de la grandeur, permet de faire un réglage fin par approximations successives avec possibilité de retour en arrière en cas de dépassement de la valeur souhaitée.

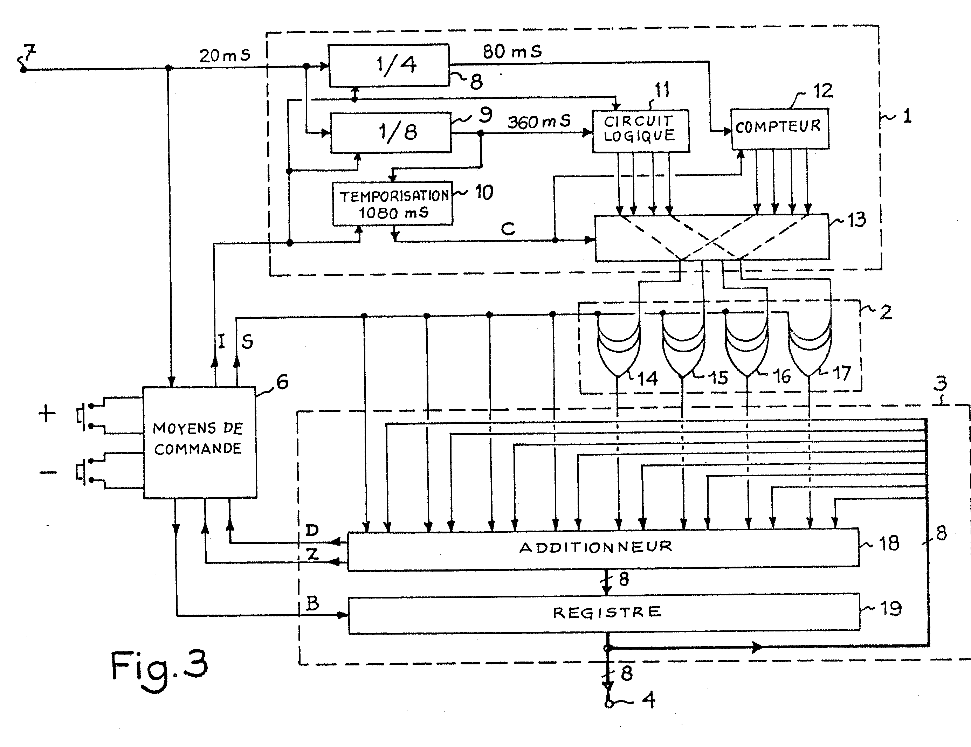

La figure 3 représente le schéma synoptique d'un exemple de réalisation du dispositif selon l'invention. Il comporte deux commutateurs à bouton-poussoir, "+" et "-", des moyens 1 pour calculer à intervalles réguliers la valeur absolue d'une variation ; des moyens 2 pour donner à la valeur de la variation un signe positif ou négatif ; et des moyens 3 pour additionner la suite de toutes les valeurs de la variation et pour limiter la somme obtenue entre deux bornes ; et des moyens de commande 6. Les moyens de commande 6 possèdent une première entrée reliée à une borne d'entrée 7 du dispositif selon l'invention, une seconde entrée reliée à une sortie des moyens 3, fournissant un signal logique D, et une troisième entrée reliée à une sortie des moyens 3, fournissant un signal logique Z. Les moyens de commande 6 possèdent une première sortie fournissant un signal logique I à une entrée des moyens 1, une seconde sortie fournissant un signal S d'une part à une entrée des moyens 2, et d'autre part à des entrées des moyens 3, et une troisième sortie fournissant un signal B à une entrée des moyens 3.

Les moyens 1 sont constitués d'un diviseur de fréquence 8, de rapport 4, d'un diviseur de fréquence 9, de rapport 18, d'un temporisateur 10, d'un circuit logique 11, d'un compteur 12, et d'un multiplexeur 13 ayant deux entrées de quatre bits et une sortie de quatre bits. Le diviseur de fréquence 8 possède une entrée reliée à la borne d'entrée 7 du dispositif selon l'invention, pour recevoir un signal d'horloge de période 20 mS, une entrée de remise à zéro recevant le signal I fourni par les moyens de commande 6, et une sortie fournissant un signal d'horloge de période 80 mS à une entrée d'horloge du compteur 12. Le diviseur de fréquence 9 possède une entrée reliée à la borne d'entrée 7, une entrée de remise à zéro recevant le signal I, et une sortie fournissant un signal d'horloge de période 360 mS, d'une part à une entrée d'horloge du circuit logique 11 et, d'autre part, à une entrée d'horloge du temporisateur 10. Le temporisateur 10 possède en outre une entrée de remise à zéro recevant le signal I, et une sortie fournissant un signal logique à une entrée

6

d'initialisation du compteur 12 et à une entrée de commande du multiplexeur 13. Le circuit logique 11 et le compteur 12 fournissent chacun un mot binaire de quatre bits respectivement à une première et à une seconde entrée multiple du multiplexeur 13. Le multiplexeur 13 transmet l'un de ces deux mots binaires à quatre sorties des moyens 1 qui sont reliés respectivement à quatre entrées des moyens 2. Ceux-ci sont constitués de quatre portes logiques OU EXCLUSIF, 14, 15, 16, 17. Chacune de ces portes possède une première entrée recevant le signal S fourni par les moyens de commande 6, et une seconde entrée recevant respectivement l'un des quatre bits fournis par le multiplexeur 13. Chacune de ces portes possède une sortie reliée à une entrée des moyens 3.

Les moyens 3 sont constitués d'un additionneur 18, pour additionner deux mots de huit bits, et d'un registre 19 pour stocker un mot de huit bits. L'additionneur 18 comporte huit étages ayant chacun une première et une seconde entrée pour un bit. Les premières entrées des quatre étages de poids le plus faible sont reliés respectivement aux quatre sorties des moyens 2, et les premières entrées des quatre autres étages reçoivent le signal logique S. Les huit secondes entrées de l'additionneur 18 sont reliées respectivement à huit sorties du registre 19. Le registre 19 est un registre verrou à huit étages, ayant huit entrées reliées respectivement à huit sorties de l'additionneur 18. Les huit sorties du registre 19 sont reliées aussi à une borne de sortie multiple 4 constituant une borne de sortie du dispositif selon l'invention. Une sortie de l'additionneur 18 fournit le signal logique D lorsqu'il y a un dépassement de la capacité de l'additionneur 18, et le signal logique Z lorsque le résultat de l'addition est égal à 0. Le registre 19 possède une entrée de commande recevant le signal logique B fourni par les moyens de commande 6.

Pour chaque trame d'une suite d'images de télévision, dont le signal vidéo est traité par un dispositif numérique relié au dispositif représenté, la borne d'entrée 7 reçoit une impulsion qui constitue une impulsion d'horloge pour le dispositif selon l'invention. Les diviseurs de fréquence 8 et 9 fournissent deux autres signaux d'horloge ayant pour période 80 mS et 360 mS. A un instant, dit instant initial, un opérateur appuie sur l'un des commutateurs à bouton-poussoir, "+" ou "-", les moyens de commande 6 génèrent alors le signal logique I pour initialiser les diviseurs de fréquence 8 et 9, le circuit logique 11, et le temporisateur 10. Pendant un intervalle de temps de 1080 mS, le temporisateur 10 ne fournit pas le signal logique C, le multiplexeur 13 transmet la valeur des quatre bits fournis par le circuit logique 11. Le circuit logique 11 peut être constitué d'un compteur déclenché par le signal d'horloge de période 360 mS, remis à zéro par le signal logique I, et dont les sorties sont décodées par un décodeur. Le circuit logique 11 fournit un mot binaire de valeur 1 à l'instant initial, puis de valeur 2 après un délai de 360 mS, puis de valeur 4 après un délai supplémentaire de 360 mS.

1080 mS après l'instant initial le temporisateur 10 fournit le signal logique C qui commande le multiplexeur 13 de façon à transmettre le mot binaire fourni par le compteur 12. Le compteur 12 est initialisé à la valeur 4 puis est incrémenté de deux en deux sous l'action du signal d'horloge de période 80 mS. La valeur transmise à la sortie du multiplexeur 13 est donc la valeur absolue V de la variation du mot binaire commandant la grandeur à régler, telle qu'elle est représentée sur la figure 1.

Si l'opérateur est en train d'appuyer sur le bouton-poussoir du commutateur "+", le signal logique S, fourni par les moyens de commande 6, a la valeur 0. Les portes OU EXCLUSIF 14 à 17 transmettent le mot binaire fourni par le multiplexeur 13, sans le modifier. Dans le cas contraire ce mot binaire est complémenté à 1 d'une part, et, d'autre part, les premières entrées des quatre étages de plus grand poids de l'additionneur 18 reçoivent un bit de valeur 1, ce qui correspond à un changement de signe de la valeur de la variation. Les secondes entrées de l'additionneur 18 reçoivent respectivement les valeurs des huit bits stockés dans le registre 19 et qui constituent la valeur du mot binaire commandant la grandeur à l'instant considéré. L'additionneur 18 et le registre 19 constituent un accumulateur qui additionne la suite de toutes les valeurs algébriques de la variation, appliquées sur les premières entrées de l'additionneur 18. L'additionneur 18 fournit le signal logique D lorsque sa capacité est dépassée, c'est-à-dire lorsque la somme dépasse la valeur 255 qui est sa borne supérieure. L'additionneur 18 fournit le signal logique Z lorsque la somme atteint la valeur 0 qui est sa borne inférieure. La valeur fournie par l'additionneur 18 est stockée dans le registre 19 sous l'action du signal logique B fourni par les moyens de commande 6 toutes les 20 mS.

Quand la somme a atteint l'une de ces bornes les moyens de commande 6 ne fournissent plus le signal B tant que l'opérateur n'actionne pas le commutateur permettant de faire varier la somme dans un sens opposé. Chaque fois que l'un des commutateurs à bouton-poussoir, "+" ou "-", est actionné, les moyens de commande 6 génèrent le signal I pour réinitialiser les diviseurs de fréquence 8 et 9, le temporisateur 10, et le circuit logique 11 ; par conséquent tout relâchement des boutons-poussoirs permet de repasser à une vitesse de réglage lente.

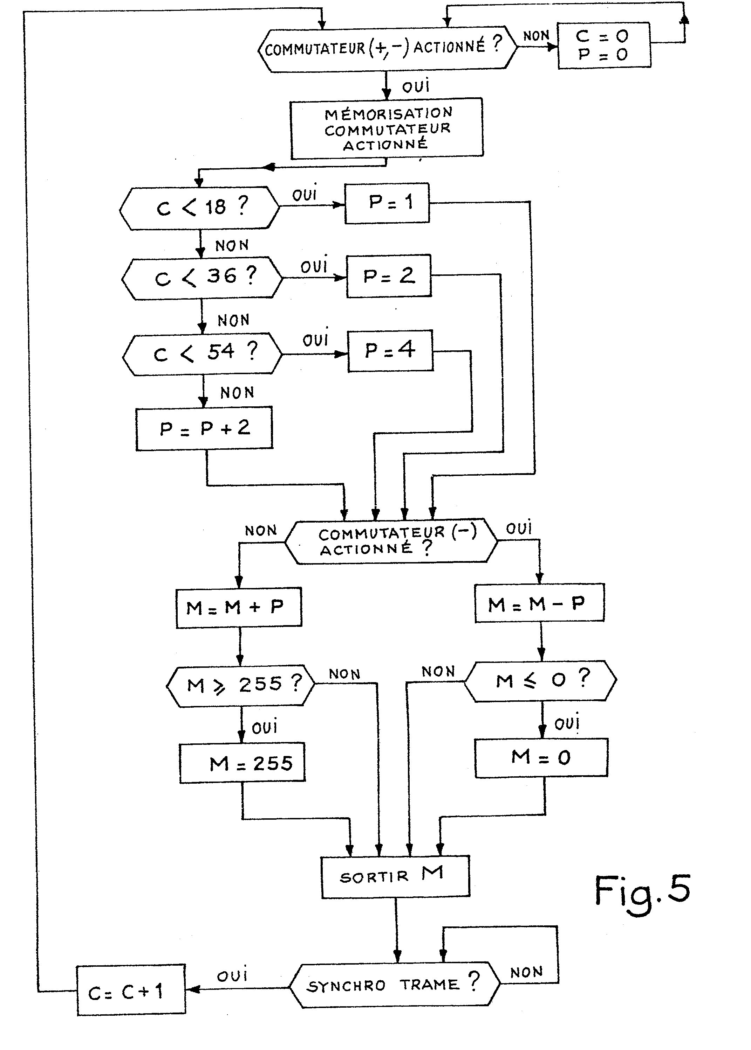

La figure 4 représente le schéma synoptique d'un second exemple de réalisation du dispositif selon l'invention, particulièrement avantageux lorsqu'il s'agit de commander un dispositif numérique comportant déjà un microprocesseur pour réaliser d'autres tâches. C'est le cas, par exemple, d'un analyseur d'images fixes avec traitement numérique du signal vidéo. Un même microprocesseur est utilisé pour d'autres tâches, et pour déterminer les réglages. Un microprocesseur 20 constitue des moyens pour calculer à intervalles réguliers la valeur absolue d'une variation, pour donner à cette valeur un signe positif ou négatif, et pour additionner la suite de toutes les valeurs de la variation et limiter la somme obtenue entre deux bornes. Dans cet exemple de réalisation le programme du microprocesseur 20 est supposé stocké dans une mémoire incorporée à celui-ci. Le dispositif comporte en outre une interface d'entrée 21 et une interface de sortie 22 reliées au microprocesseur 20 par un bus bidirectionnel pour des données de huit bits et par un bus d'adresses de sept bits. Deux commutateurs à bouton-poussoir, "+" et "-", et une borne d'entrée 25 sont reliés à l'interface d'entrée 21. Une borne de sortie multiple 24 constitue la sortie du dispositif selon l'invention et transmet un mot binaire de huit bits fourni par l'interface de sortie 22. L'horloge du microprocesseur 20 n'est pas représentée sur la figure 4 ; sa réalisation est à la portée de l'homme de l'art. Le programme du microprocesseur 20 comporte une temporisation permettant de calculer une valeur de variation toutes les 20 mS. Dans cet exemple de réalisation cette temporisation est synchronisée sur un signal de synchronisation de trame, appliqué sur la borne 25, car ce dispositif fait partie d'un dispositif de traitement numérique de signaux vidéo.

La figure 5 représente un organigramme pouvant être utilisé pour programmer cet exemple de réalisation, et le faire fonctionner de la façon décrite par les figures 1 et 2.

Lorsqu'aucun des commutateurs "+" et "-" n'est actionné le microprocesseur 20 est en attente, il scrute périodiquement l'état des commutateurs "+" et "-", en décrivant une boucle dans laquelle des variables C et P sont remises à zéro. La variable C représente le nombre d'intervalles de temps, de durée 20 mS, écoulés depuis un instant initial où l'un des commutateurs a été actionné sans interruption, et la variable P représente la valeur absolue de la pente, mesurée sur un intervalle de 20 mS, de la variation de la valeur du mot binaire commandant la grandeur à régler. Dans la suite la valeur de ce mot binaire est représentée par la variable M. Quand l'un des commutateurs, "+" ou "-", est actionné, le microprocesseur stocke dans sa mémoire un bit désignant ce commutateur puis compare la valeur de la variable C successivement aux valeurs 18, 36, et 54. Si la valeur C est inférieure à 18, c'est-à-dire si le nombre d'intervalles de 20 mS, écoulés depuis que le commutateur a été actionné sans interruption, est inférieur à 18, alors la valeur 1 est attribuée à la variable P. Si la valeur de C est comprise entre 18 et 36, c'est-à-dire si l'action sur le commutateur dure depuis plus de 320 mS et moins 720 mS, alors la valeur 2 est attribuée à la variable P. Si la valeur de C est comprise entre 36 et 54, c'est-à-dire si l'action sur commutateur dure depuis au moins 720 mS et moins de 1080 mS, alors la valeur 4 est attribuée à la variable P. Si la valeur de C est supérieure ou égale à 54, c'est-à-dire si l'action sur le commutateur dure depuis au moins 1080 mS, la valeur de P est simplement augmentée de deux unités.

La valeur de P fournit, à ce stade du calcul, la valeur absolue de la pente de la variation de la valeur M du mot binaire commandant la grandeur à régler. Le microprocesseur détermine ensuite quel est le commutateur qui est actionné en testant la valeur du bit désignant ce commutateur. Si c'est le commutateur "+" qui est actionné, la valeur de la variable P est ajoutée à la valeur de la variable M, qui est la valeur conservée depuis le dernier réglage, ou bien qui est une valeur initiale chargée lors de la mise sous tension du microprocesseur 20. La valeur de la variable M est comparée par rapport à sa borne supérieure : 255. Si elle est supérieure ou égale à cette borne, elle est remplacée par la valeur maximale qui est 255.

Si c'est le commutateur "-" qui est actionné, la valeur de la variable P est soustraite à la valeur de la variable M. La valeur de M est ensuite comparée à sa borne inférieure, qui est zéro. Si elle est inférieure ou égale à zéro, elle est remplacée par la valeur minimale qui est 0. Sinon elle est inchangée.

Dans les deux cas le microprocesseur fournit ensuite la valeur de la variable M sur la borne de sortie 24 par l'intermédiaire de l'interface de sortie 22. Il décrit ensuite une boucle d'attente jusqu'à ce qu'il détecte une impulsion de synchronisation de trame, appliquée à la borne d'entrée 25 et transmise par l'interface d'entrée 21. Après une attente d'environ 20 mS, la détection d'une impulsion de synchronisation de trame déclenche une augmentation d'une unité de la variable C comptant le nombre de passages dans la boucle de programme, et provoque le retour au début du programme, c'est-à-dire à une scrutation des commutateurs "+" et "-" . Si le même commutateur reste encore actionné, le microprocesseur teste la valeur de la variable C afin de connaître le nombre d'intervalles de 20 mS écoulés depuis l'instant où le commutateur a été actionné. Si le commutateur n'est plus actionné le microprocesseur réinitialise la variable C et la variable P. Il recommence cette opération indéfiniment tant qu'aucun des deux commutateurs n'est actionné.

Dans ces deux exemples de réalisation la valeur du mot binaire commandant la grandeur à régler est modifiée toutes les 20 mS, c'est-à-dire une fois pour chaque trame d'une suite d'images de télévision de standard européen. Si cet intervalle était beacoup plus long il apparaîtrait des discontinuités, visibles et gênantes, dans la suite d'images, car pour conserver la même durée de réglage la valeur absolue de chaque variation serait plus importante. Dans d'autres applications il est possible de modifier la valeur du mot binaire à un rythme plus rapide, à condition de réduire la valeur absolue des variations de façon à conserver une durée de réglage analogue.

L'invention ne se limite pas aux deux exemples de réalisation décrit ci-dessus, il est à la portée de l'homme de l'art d'adapter ces exemples pour réaliser des réglages d'une grandeur pouvant prendre des valeurs positives ou négatives, et commandable par un nombre de bits différent. Le deuxième exemple de réalisation est notamment adaptable pour réaliser avec un seul processeur les réglages de plusieurs grandeurs ayant des gammes différentes, par exemple des grandeurs commandables par un mot de huit bits et des grandeurs commandables par un mot de douze bits. Il est possible aussi de réaliser une progression différente des valeurs de la variation, l'essentiel étant que la variation ait une valeur minimale lorsque la durée de l'action sur un bouton-poussoir est faible, puis croisse avec une pente qui augmente rapidement en fonction du temps de façon à pouvoir parcourir toute la gamme de réglage en un temps raisonnable. Il est possible aussi de limiter la valeur absolue P de la variation à une valeur maximale donnée, pour stabiliser la vitesse d'excursion, au-delà d'un certain temps.

12

## REVENDICATIONS

1. Dispositif de commande manuelle différentielle, pour régler une grandeur commandable par la valeur M d'un mot binaire, caractérisé en ce qu'il comporte :

- un premier commutateur manuel ("+"), pour commander une augmentation de la grandeur ;

- un second commutateur manuel ("-") pour commander une diminution de la grandeur ;

- des moyens (1 ou 20) pour calculer à intervalles réguliers la valeur absolue d'une variation de la valeur M, quand l'un des commutateurs ("+" ou "-") est actionné, en fonction de la durée pendant laquelle il est actionné sans interruption ; la durée des intervalles étant choisie de façon à rendre imperceptible les discontinuités du réglage ;

- des moyens (2 ou 20) pour donner, à la valeur de la variation, un signe positif ou négatif selon le commutateur ("+" ou "-") qui est actionné ;

- des moyens (3 ou 20) pour additionner la suite de toutes les valeurs de la variation et pour limiter entre deux bornes la somme obtenue, cette dernière constituant la valeur M du mot binaire commandant la grandeur à régler.

2. Dispositif selon la revendication 1, caractérisé en ce que les moyens (1 ou 20) pour calculer à intervalles réguliers la valeur absolue de la variation fournissent une valeur absolue croissante en fonction de la durée pendant laquelle est actionné sans interruption l'un des commutateurs ("+" ou "-"), cette valeur absolue étant ramenée à une valeur minimale après toute interruption, et cette valeur minimale correspondant à la précision souhaitée pour régler la grandeur.

3. Dispositif selon la revendication 2, caractérisé en ce que les moyens (1 ou 20), pour calculer la valeur absolue de la variation fournissent une valeur dont la pente, en valeur absolue, est une fonction croissante de la durée pendant laquelle un des commutateurs ("+" ou "-") est actionné sans interruption, afin de permettre un réglage précis lorsque cette durée est faible, et afin de permettre un réglage parcourant rapidement toute la gamme de réglage, lorsque cette durée est longue.

0124406

Fig.1

Fig.4

0124406

2|4

Fig.2

Fig.3

Fig.5

0124406

**Office européen des brevets**

## RAPPORT DE RECHERCHE EUROPEENNE

Numéro de la demande

EP  84 40 0685

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | US-A-4 328 539  (HEEGER)<br>* figures 3-5; revendication 10; colonne 4, lignes 34-60; colonne 10, ligne 41 - colonne 13, ligne 9 *<br><br>--- | 1,3 | H 03 G    3/04<br>G 05 B   19/21 |
| A | GB-A-1 496 653  (RANCO CONTROLS)<br>* figures; page 2, lignes 10-82; page 3, lignes 26-36; page 4, ligne 113 - page 6, ligne 51 *<br><br>--- | 1,3 | |
| A | DE-A-2 935 306   (HITACHI)<br>* figures 1,2; page 12, ligne 1 - page 16, dernière ligne *<br><br>--- | 1 | |
| A | FR-A-2 400 227  (EBAUCHES)<br>* figure 1; page 4, ligne 6 - page 7, ligne 24 *<br><br>--- | 1 | DOMAINES TECHNIQUES RECHERCHES (Int. Cl. 3) |
| A | PATENTS ABSTRACTS OF JAPAN, vol. 7, no. 17 (E-154)(1162), 22 janvier 1983, page 1162E154, & JP - A - 57 173 208 (SONY K.K.)(25-10-1982).<br>* en entier *<br><br>----- | 1 | H 03 G<br>H 03 J<br>G 04 G<br>H 04 N<br>G 05 B |

Le présent rapport de recherche a été établi pour toutes les revendications

| Lieu de la recherche | Date d'achèvement de la recherche | Examinateur |
|---|---|---|
| LA HAYE | 16-07-1984 | GYSEN L.A.D. |

OEB-Form 1503. 03 82